# EUROPÄISCHE PATENTSCHRIFT

(11) **EP 2 206 153 B1**
(45) Veröffentlichungstag und Bekanntmachung des Hinweises auf die Patenterteilung: **04.04.2012**
(21) Anmeldenummer: 08847695.7
(22) Anmeldetag: 04.11.2008
(51) Int. Cl.: H01L 29/06, B05D 1/42, B05D 5/00

(54) **VERFAHREN ZUR NANOSTRUKTURERZEUGUNG MITTELS SPINODALER ENTNETZUNG**
METHOD FOR THE PRODUCTION OF A NANOSTRUCTURE BY MEANS OF SPINODAL DECROSSLINKING
PROCÉDÉ DE PRODUCTION DE NANOSTRUCTURES PAR DÉMOUILLAGE SPINODAL

(30) Priorität: 08.11.2007 DE 102007053157
(43) Veröffentlichungstag der Anmeldung: 14.07.2010
(73) Patentinhaber: Christian-Albrechts-Universität Zu Kiel, 24118 Kiel (DE)
(72) Erfinder: FAUPEL, Franz, 24226 Heikendorf (DE); ADELUNG, Rainer, D-24116 Kiel (DE); ELBAHRI, Mady, 24104 Kiel (DE); HIRMAS, Khaled, Tripoli (LY)
(74) Vertreter: Biehl, Christian
(86) Internationale Anmeldenummer: PCT/DE2008/001801
(87) Internationale Veröffentlichungsnummer: WO 2009/059583

(56) Entgegenhaltungen:
- US-A1- 2009 020 924
- JUN XU ET AL: "Self-Assembly of Gradient Concentric Rings via Solvent Evaporation from a Capillary Bridge" PHYSICAL REVIEW LETTERS, Bd. 96, Nr. 6, 17. Februar 2006 (2006-02-17), Seiten 066104/1-066104/4, XP002528374 APS USA ISSN: 0031-9007
- HUANG J ET AL: "One-Step Patterning of Aligned Nanowire Arrays by Programmed dip Coating" ANGEWANDTE CHEMIE - INTERNATIONAL EDITION, Bd. 46, Nr. 14, 27. Februar 2007 (2007-02-27), Seiten 2414-2417, XP002528115 WILEY-VCH VERLAG DE in der Anmeldung erwähnt
- VERMA R ET AL: "Spinodal instability and pattern formation in thin liquid films confined between two plates" JOURNAL OF COLLOID AND INTERFACE SCIENCE, Bd. 296, Nr. 1, 1. April 2006 (2006-04-01), Seiten 220-232, XP024909231 ACADEMIC PRESS, NEW YORK, NY, US ISSN: 0021-9797 [gefunden am 2006-04-01]
- SUCK WON HONG ET AL: "Template-Assisted Formation of Gradient Concentric Gold Rings" NANO LETTERS, Bd. 6, Nr. 12, 16. November 2006 (2006-11-16), Seiten 2949-2954, XP002528375 AMERICAN CHEM. SOC USA ISSN: 1530-6984
- KARGUPTA K ET AL: "Creation of Ordered Patterns by Dewetting of Thin Films on Homogeneous and Heterogeneous Substrates" JOURNAL OF COLLOID AND INTERFACE SCIENCE, Bd. 245, Nr. 1, 2002, Seiten 99-115, XP002528116 ELSEVIER US in der Anmeldung erwähnt
- SUCK WON HONG, WONJE JEONG, HYUNHYUB KO, MICHAEL R. KESSLER, VLADIMIR V. TSUKRUK, ZHIQUN LIN: "Directed Self-Assembly of Gradient Concentric Carbon Nanotube Rings" ADV. FUNCT. MATER., [Online] Bd. 18, 9. Juli 2008 (2008-07-09), Seiten 1-9, XP002528114 Weinheim DOI 10.1002/adfm.200800135 Gefunden im Internet: URL:http://www3.interscience.wiley.com/jou rnal/120735449/abstract?CRETRY=1&SRETRY=0> [gefunden am 2009-05-15]
- HONG SUCK WON ET AL: "Robust self-asembly of highly ordered Complex Structures by Controlled Evaporation of Confined Microfluids" ANGEWANDTE CHEMIE - INTERNATIONAL ED. IN ENGLISH, Bd. 48, Nr. 3, 22. November 2008 (2008-11-22), Seiten 512-516, XP002528117 ISSN: 1521-3773

## Beschreibung

Die Erfindung betrifft ein Verfahren zur Erzeugung von regelmäßig angeordneten Nanodrähten und Nanodraht-Gitterstrukturen.

Die reproduzierbare Herstellung nanoskaliger Strukturen steht im Fokus aktueller Forschung, u. a. weil sich eine Vielzahl von Anwendungen bei der Device-Fertigung absehen lassen, z.B. in den Bereichen Photonik und Elektronik, Sensortechnologie und Biotechnologie (z.B. Labon-Chip). Bekannte physikalische Strukturierungsmethoden wie Lithographie sind für die Nanometerskala nur bedingt anwendbar und zudem aufwendig und teuer. Mehr Aufmerksamkeit wird deshalb in letzter Zeit der selbstorganisierten Strukturbildung ("Self Assembly") aus Nanopartikeln gewidmet, die allerdings nicht unbedingt zu technisch brauchbaren, insbesondere regelmäßigen Strukturen führt.

Nach inzwischen weit verbreiteter Auffassung liegt der Schlüssel zur Massenfertigung von Nanostrukturen in der Entwicklung geeigneter Kontrollverfahren, die der selbstorganisierten Strukturbildung sozusagen "die gewünschte Richtung geben". Zugleich werden immer noch weitere Phänomene der Nanoselbststrukturierung entdeckt und daraufhin untersucht, ob sie einen günstigen Ansatzpunkt für ein solches Kontrollverfahren offerieren.

Ein solches Phänomen ist beim Verdunsten bzw. langsamen Verdampfen eines Tropfens einer Kolloidsuspension auf einem Substrat zu beobachten. Hierbei entstehen, nachdem das Lösungsmittel komplett entfernt worden ist, typisch ringförmige Ablagerungen des Kolloidmaterials als Hinterlassenschaft auf dem Substrat. Interessanterweise bildet sich so eine Anordnung weitgehend separierter Ringe des Kolloidmaterials, und eben keine flächige Verteilung, wie man es naiv erwarten würde.

Zur Erklärung dieses auch als "coffee stain effect" bezeichneten Phänomens erläutert Deegan in seiner Dissertation "DEPOSITION AT PINNED AND DEPINNED CONTACT LINES: PATTERN FORMATION AND APPLICATIONS" (University of Chikago, 1998), dass die begrenzende Kontaktlinie des Suspensionstropfens - also der Tropfenrandverlauf - von Störstellen auf dem Substrat auch während der Verdunstung fixiert ("pinned") wird. Dies führt zu einer Ansammlung von Kolloidpartikeln entlang der Kontaktlinie, was wiederum sogar zu einer Verstärkung der Fixierung ("Self-pinning") und zu einem Transport weiterer Suspension zur Kontaktlinie führt. Auf diese Weise reichern sich Partikel an der Kontaktlinie solange an bis der Transport zusammenbricht. Der inzwischen reduzierte, aber immer noch existente Tropfen zieht sich dabei praktisch sprunghaft zusammen, d.h. er bildet eine neue, enger liegende Kontaktlinie zum Substrat aus, und die Prozesse wiederholen sich dort. Schließlich findet man eine Mehrzahl mehr oder weniger konzentrischer Ringe aus Kolloidmaterial, wenn das Lösungsmittel vollständig verdunstet ist.

Das beschriebene Phänomen wird in der Literatur auch als Nanostrukturbildung durch "contact line pinning" tituliert. Die gefundenen Strukturen sind jedoch üblich einige Mikrometer breit, auch wenn sie aus nanoskaligen Konstituenten hervorgehen. Überdies sind sie - infolge runder Tropfenkontaktlinien - prinzipiell ringförmig und bilden nicht ohne weiteres regehnä-βige Muster. Zudem ist eine Kolloidsuspension Voraussetzung für das Gelingen des "contact line pinning".

Ein Beispiel für die Herstellung paralleler Drähte mit einem solchen Verfahren ist der Arbeit von Huang et al., "One-Step Patterning of Aligned Nanowire Arrays by Programmed Dip Coating" (Angew. Chem. Int. Ed. 2007, 46, 2414 -2417) zu entnehmen. Ein vertikal orientiertes Substrat wird dabei mit definierter Geschwindigkeit aus einer Partikelsuspension herausgezogen, so dass sich entlang einer geraden Kontaktlinie Partikel zu einer linearen Struktur ansammeln. Das Herausziehen des Substrats dünnt - wie beim trocknenden Tropfen - den am Substrat haftenden und an der Kontaktlinie fixierten Suspensionsfilm zusehends aus bis schließlich sprunghaft eine neue, tiefer gelegene Kontaktlinie angenommen wird. Im Ergebnis entsteht auf dem Substrat einer Anordnung paralleler, gleichmäßig beabstandeter Drähte, deren Abstand über die Herausziehgeschwindigkeit kontrollierbar ist.

Ein Nachteil dieses Verfahrens liegt auch hier in den erheblichen Strukturbreiten von einigen Mikrometern. Überdies ist es zweifelhaft, ob sich - etwa durch Drehen des Substrats um einen Winkel und Wiederholen der gesamten Prozedur - auf diese Weise auch überkreuzende Drähte oder sogar ganze Gitternetze erzeugen lassen, denn die dann bereits vorhandenen Drähte dürften mit dem Verlauf der Benetzungsgrenze der Suspension interferieren, insbesondere die Fixierung der Kontaktlinie behindern. Auf jeden Fall sagen die Autoren des zitierten Artikels nichts zu Gitternetzen, obwohl deren Erzeugung mit ihrer Methode sich geradezu aufdrängen würde.

Aus der Arbeit von Padmakar et al., "Instability and dewetting of evaporating thin water films on partially and completely wettable substrates" (J. Chem. Phys., Vol. 110, 1735-1744, 1999) ist eine Erklärung für ein anderes Strukturbildungsphänomen bei der Verdampfung wässriger Tropfen oder Filme zu entnehmen.

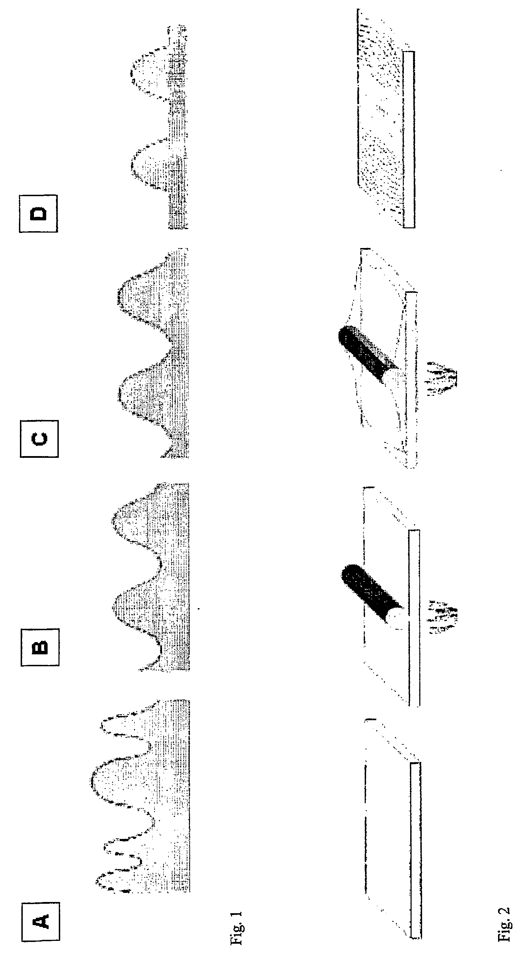

Ein wässriger Dünnfilm weist prinzipiell eine gewisse Rauheit an seiner Oberfläche auf, d.h. die tatsächliche Filmdicke ist eine Funktion h(r, t), wobei r eine Ortkoordinate längs des Substrats und t die Zeit bezeichnen soll. Die Schwankungsbreite der Filmdicke Δh ist temperaturabhängig und kann während des Verdampfens des Films die Größenordnung der abnehmenden mittleren Filmdicke <h>(t)=∫ h(r, t) dr erreichen. Auch ohne näheres Eingehen auf die theoretische Diskussion von Padmakar et al. ist ohne weiteres einsichtig, dass der Film dabei instabil werden kann. Es können praktisch Löcher im Film, die bis auf das Substrat reichen, entstehen, und die Filmdicke kann eine weitgehend periodische Struktur annehmen. Diese Löcher können Ausgangspunkte einer Vereinzelung von "Restfilmstücken" sein - mithin also zur Tröpfchenbildung führen (vgl. Fig. 1 als Veranschaulichung). Die Tröpfchen verdampfen danach getrennt voneinander vollständig. Dieses Phänomen der spontanen, regelmäßigen Entnetzung dünner Filme, das sich nicht nur an Wasser, sondern vor allem an organischen Flüssigfilmen, aber auch an verflüssigten Metallfilmen zeigt, ist der Fachwelt als "spinodale Entnetzung" bzw. "spinodal dewetting" bekannt. Eine genauere physikalische Erläuterung findet sich u. a. in dem Artikel von Jacobs und Herminghaus, "Strukturbildung in dünnen Filme", Physikalische Blätter, 55 (1999), Nr. 12.

Die Arbeit von Padmakar et al. zeigt auf, dass charakteristische Längen für die Unterteilung des Films existieren, die insbesondere von der Geschwindigkeit der Verdampfung abhängen. Sie weist somit einen Weg zur regelmäßigen Filmstrukturierung auch ohne Beteiligung von Kolloiden und gibt Hinweise auf die Kontrolle von Strukturgrößen über die Temperatur.

Bereits in dem Artikel von Weiss, "To Bead or Not to Bead?" (Science News, Vol. 155, S. 28, 1999) wird auf die Ansicht verwiesen, dass spinodale Entnetzung zur Erzeugung von Mustern und Strukturen (z.B. aus Nanopartikeln) auf Substraten geeignet sei, deren Abmessungen tatsächlich auf der Skala von Nanometern liegen.

Die Dissertation von Rath, "Periodisch angeordnete photochrome Dots für hochdichte optische Speicher", Universität Stuttgart, 2007, beschreibt die Erzeugung gleichmäßig großer Quantendots (Durchmesser einige 10 bis wenige 100 nm) in streng periodischer Anordnung mittels spinodaler Entnetzung. Allerdings gelingt dies nicht auf einem flachen Substrat, wo sich nur verschieden große Dots in zufälliger Verteilung bilden. Rath nutzt deshalb vorstrukturierte, mit Gräben versehene Substrate.

Zum Stand der Technik wird weiter auf K. Kargupta, A. Sharma: "Creation of Ordered Pattems by Dewetting of Thin Films on Homogenous an Heterogenous Substrates", Journal of Colloid and Interface Science, Volume 245, pp. 99-115 (2002) und A.M. Higgins and R.A.L. Jones: "Anisotropic spinodal dewetting as a rute to self-assembly of patterned surfaces", Nature 404, pp 476-478 (2000) hingewiesen. Ausgehend von dem vorgenannten Stand der Technik stellt sich die Erfindung nun die Aufgabe, ein einfaches Verfahren zur Herstellung von Nanodrahtstrukturen, insbesondere von Nanogittern anzugeben, bei der die erzeugten Strukturbreiten der einzelnen Nanodrähte in der Größenordnung von 100 Nanometern liegen.

Die Aufgabe wird gelöst durch ein Verfahren gemäß Anspruch 1. Die Unteransprüche geben vorteilhafte Ausgestaltungen an. Die grundlegende Vorgehensweise der Erfindung ist die folgende:
Das die Nanostruktur bildende Material wird in eine Trägerflüssigkeit gebracht, wobei zu beachten ist, dass keine wesentlichen Mengen des Materials unmittelbar nach Einsetzen einer Verdampfung der Trägerflüssigkeit ausgeschieden werden können. Die Beladung der Trägerflüssigkeit muss also deutlich unter der Beladungskapazität bleiben.

Die materialbeladene Trägerflüssigkeit wird auf ein flaches, nicht vorstrukturiertes Material aufgebracht, sodass sich ein Flüssigkeitsfilm auf dem Substrat bildet.

Die Dicke des Flüssigkeitsfilm h(r, t) ist nicht gleichmäßig, sondern sie variiert entlang der Substratoberfläche auch hinsichtlich ihres lokalen Mittelwertes <h>(r₀, t) = ∫_{Ω} h(r, t) dr, wobei das Mittelungsintegral sich über eine kleine Umgebung Ω um den Punkt r₀ erstreckt. Es sind erfindungsgemäß Maßnahmen zu treffen, um den Gradienten ∇ᵣ₀ <h>(r0, t) über größere Flächenbereiche des Substrats möglichst gleich, zumindest aber möglichst parallel einzurichten.

Das filmbenetzte Substrat wird möglichst gleichmäßig auf eine erhöhte Temperatur unterhalb des Siedepunktes der Trägerflüssigkeit gebracht, damit diese rasch und unter Ausbildung erheblicher Oberflächenrauheit verdampft. Die Filmdicke nimmt dadurch überall schnell ab, jedoch bildet sich nur in jenem Teilbereich der benetzten Fläche mit "passender" Filmdicke spinodale Entnetzung und damit eine Strukturierung des Filmes aus. Der Bereich passender Filmdicke "wandert" während der fortschreitenden Verdampfung über das Substrat. Der Strukturverlauf erweist sich als senkrecht zum jeweiligen lokalen Gradienten der Filmdicke ∇ᵣ₀ <h>(r0, t).

Ist die gesamte Trägerflüssigkeit verdampft, verbleibt das die Nanostruktur bildende Material vorrangig - und wie sich zeigt sehr selektiv - auf jenen Flächenbereichen, die beim Auftreten der spinodalen Entnetzung zuletzt noch benetzt waren. Die Strukturbreiten sind sehr gering, und die Strukturen verlaufen insbesondere dort parallel, wo ein weiter Bereich mit parallelem Filmdickengradienten vorlag.

Die erzeugten Strukturen sind relativ robust gegenüber Nachbearbeitung. Es erweist sich insbesondere als möglich, Substrate mit solchen Strukturen erneut mit der zuvor beschriebenen Methode zu bearbeiten, wobei die Richtung des Filmdickegradienten auch geändert werden kann. Auf diese Weise können sehr leicht präzise Gitterstrukturen erzeugt werden.

Es folgen einige Erläuterungen und Präzisierungen:
Die erfindungsgemäß vorgesehene spinodale Entnetzung der Trägerflüssigkeit bewirkt die Strukturierung des flüssigen Films prinzipiell unabhängig von den Flüssigkeitsrändern. Allerdings wird in jeder praktischen Anwendung die Trägerflüssigkeit begrenzt sein (z.B. wird ein Tropfen der Trägerflüssigkeit auf das Substrat gebracht), so dass diese Ränder die Struktur beeinflussen. Zusätzlich ergibt sich ein Einfluss auf die spinodale Strukturbildung, wenn man der Trägerflüssigkeit Kolloidpartikel zur Bildung der Nanostruktur beimengt, da dann bekanntlich "contact line pinning" einsetzt.

Die vorliegende Erfindung ist anwendbar auf Kolloidsuspensionen, aber auch auf Salzlösungen, bei denen der Mechanismus des "contact line pinning" nicht greift, da sich Strukturen auf dem Substrat beim Verdampfen erst bilden, wenn praktisch kein langreich-weitiger Materialtransport zu diesen Strukturen mehr möglich ist.

Um das Potenzial der Erfindung zu verdeutlichen, wird deshalb als Ausführungsbeispiel, welches zugleich eine bevorzugte Ausgestaltung der Erfindung realisiert, eine Salzlösung für die Strukturerzeugung verwendet. Die Trägerflüssigkeit ist hierbei Wasser. Praktisch jedes wasserlösliche Salz kann zur Bildung der Nanostrukturen benutzt werden, allerdings besteht natürlich derzeit kein wesentliches Interesse an Salz-Nanodrähten. Es wird deshalb bevorzugt Silbernitrat (AgNO₃) benutzt, da bekannt ist, dass Silbernitrat unter thermischer Behandlung in Stickoxid (NO₂), Sauerstoff und elementares Silber zerfällt. Das Ziel des Beispiels ist also die Herstellung paralleler Silberdrähte und Silbergitter.

Bei der Beladung des Wassers mit Silbernitrat ist darauf zu achten, dass man sich deutlich, bevorzugt um einen Faktor 10⁻³ bis 10⁻⁶, unter der Löslichkeitsgrenze bewegt. Würde man eine Lösung in der Nähe der Löslichkeitsgrenze ansetzen, entstünden Silbernitratausfällungen direkt nach dem Einsetzen der Wasserverdampfung, die sich nicht an der spinodalen Entnetzung orientieren. Setzt man die Lösung hingegen zu schwach konzentriert an, dann bilden sich zwar Salz-Nanodrähte mit der erwarteten Struktur, jedoch sind diese unterbrochen in Ermangelung ausreichenden Materials. Im konkreten Ausführungsbeispiel wird eine 10⁻⁵ molare Silbernitratlösung benutzt (Löslichkeit bei 20°C: 12,7 mol/l).

Die beladene Trägerflüssigkeit wird auf ein nicht vorstrukturiertes Substrat - hier: ein Siliziumwafer - getropft. Es ist bereits aus Rath (2007) bekannt und bestätigt sich durch weitere Untersuchungen, dass die Strukturbildung durch spinodale Entnetzung durch die Anwesenheit von Grabenstrukturen stark beeinflusst wird. Hier wird deshalb aufgezeigt, mit welchen erfindungsgemäßen Maßnahmen die Strukturbildung auch auf einem flachen, glatten Substrat kontrolliert werden kann.

Die Erfindung wird näher erläutert anhand der nachfolgenden Figuren. Dabei zeigt
- Fig. 1: eine schematische Darstellung des Auftretens spinodaler Entnetzung;
- Fig. 2: eine konkrete Ausgestaltung des Einrichtens eines in eine gewünschte Richtung weisenden Filmdickegradienten mit den hierdurch erzielten Strukturen;
- Fig. 3: eine Darstellung der erzielten Nanostrukturen mit einem Führungskörper (Zylinder) auf dem Substrat sowie ein Schema der Versuchsanordnung und der Ergebniserwartung;
- Fig. 4: Kraftmikroskop-Aufnahmen der erzeugten Nanodrähte (A) mit einem Linienscan (B) entlang der dargestellten Linie in A und einer Ausschnittsvergrößerung (C);
- Fig. 5: eine schematische Darstellung der Vorgehensweise zur Erzeugung von Nanogittem (A), eine Rasterelektronenmikroskop-Aufnahme eines erzeugten Gitters (B) sowie Kraftmikroskop-Aufnahmen von Gitterausschnitten (C, D).

Fig. 1 gibt die Veranschaulichung der bekannten spinodalen Entnetzung bei flüssigen Dünnfilmen wieder. Maßgeblich für ihr Auftreten ist die Erzeugung einer periodischen Rauheit der Fluidoberfläche in der Größenordnung der Filmdicke. Padmakar et al. zeigen auf, dass auch ein ausgedehnter, verdampfender Wasserfilm zur Ausbildung regelmäßiger Strukturen neigt, deren Abstände zueinander durch die Kapillarwellenlänge vorgegeben werden. Diese hängt wiederum von der Verdampfungsrate des Wassers ab.

In der vorliegenden Erfindung wird die Verdampfungsrate über die Substrattemperatur gesteuert. Wenn Wasser die Trägerflüssigkeit ist, sollte als Substrattemperatur vorzugsweise zwischen 50°C und 80°C eingestellt werden. Da lokale Temperaturgradienten im Substrat ebenfalls zur Beeinflussung des Auftretens spinodaler Entnetzung beitragen können, sollen diese hier bevorzugt vermieden werden. Deshalb wird das Substrat auf eine erhöhte Temperatur vorgeheizt (z.B. in einem Ofen), so dass noch vor der Betropfung von einer konstanten Temperatur des Substrats ausgegangen werden kann.

In Fig. 2 ist dargestellt, wie durch das Auflegen eines Führungskörpers (hier ein Glaszylinder mit Durchmesser 1,5 mm und Länge 8 mm, i. F. als Guide bezeichnet) auf das vorgeheizte Substrat die Vorgabe der Nanostrukturierung erfolgt. Beim Auftropfen der beladenen Trägerflüssigkeit auf das Substrat wirkt der Guide anziehend auf die Flüssigkeit durch die bekannte Adhäsion. Es stellt sich ein Filmdickengradient ein, der entlang des Guides senkrecht zu dessen Verlauf ausgerichtet ist. Beim Verdampfen des Films bilden sich zunächst schmale Bereiche, in denen spinodale Entnetzung auftritt, im Randbereich des Tropfens mit grob ringförmiger Ausprägung. Mit fortschreitender Verdampfung nähern sich diese Bereiche dem Guide und werden zunehmende in ihrer Form von der Gestalt des Guide dominiert. Es werden Ablagerungen (hier: Salz-Nanodrähte) als Hinterlassenschaften des verdampften Fluids gebildet, die hohe Regelmäßigkeit aufweisen und die Kontur des Guides nachvollziehen. Dabei liegen die Nanodrähte mit verringertem Abstand zum Guide immer dichter, d.h. die Kapillarwellenlänge nimmt mit fortschreitender Verdampfung ab. Es hat den Anschein, als ob der Betrag des lokalen Gradienten der Filmdicke, der unmittelbar am Guide am größten ist, die Dichte der Nanodrähte bestimmt. In jedem Fall bestimmt er die Breite des Bereichs der spinodalen Entnetzung zu einem gegebenen Zeitpunkt.

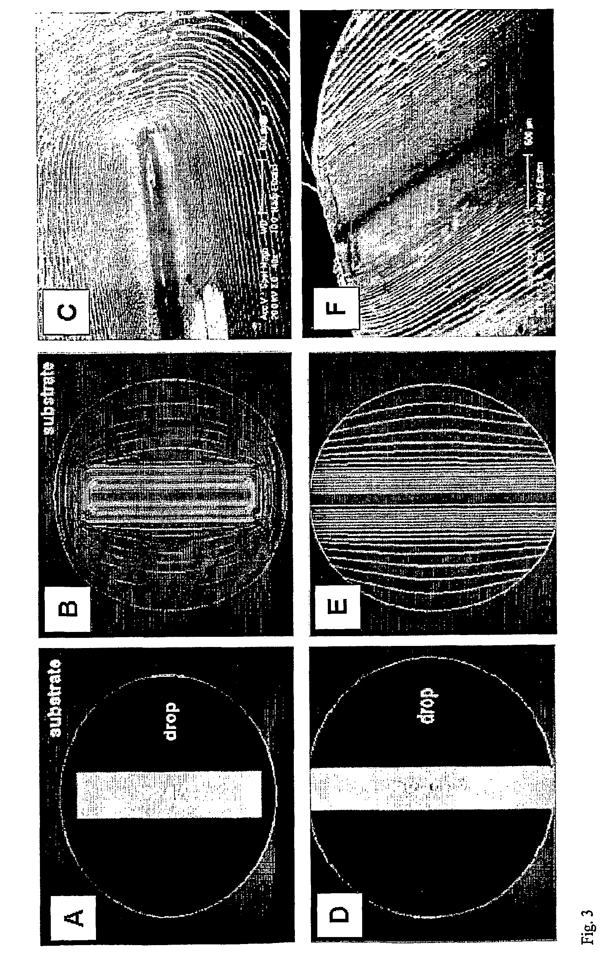

Fig. 3 zeigt die experimentellen Befunde der Umsetzung des Aufbaus aus Fig. 2. Dabei verdeutlichen die Skizzen A und D den Unterschied der oberen und unteren Bildreihe, der darin besteht, ob der Guide den Tropfenrand durchtritt oder nicht. Die Bilder B und E geben die Erwartung wieder, welche Nanostrukturen sich bilden sollten, und in C und F ist gut zu erkennen, dass diese Erwartung sehr gut erfüllt wird.

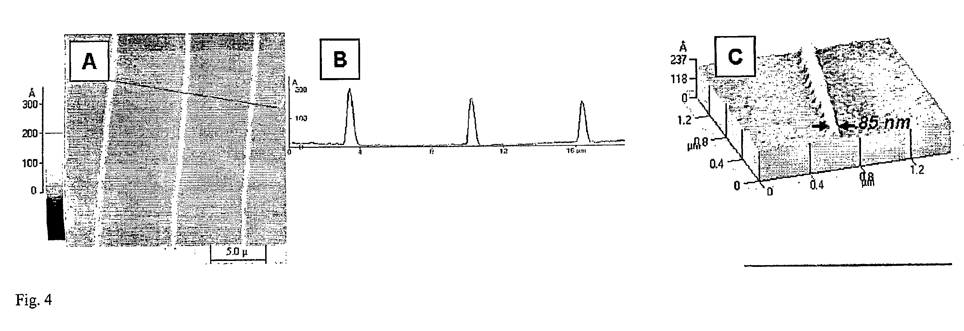

Von herausragender Bedeutung sind die sehr kleinen Abmessungen der Strukturen in unmittelbarer Nähe des Guides. Fig. 4 zeigt einen Ausschnitt dieser Strukturen aufgenommen mit dem Kraftmikroskop. In Bild A ist die Gleichmäßigkeit der Drähte und ihrer Abstände gut zu sehen. Dabei zeigt eine Schnittmessung entlang der Linie in Bild A, gezeigt als Bild B, dass die Drähte jeweils um etwa 2 nm hoch sind und diese Höhe mit dem Abstand zum Guide abnimmt. Bild C zeigt schließlich, dass die erzeugten Drähte einen Durchmesser um 100 nm aufweisen, wie es die Aufgabe dieser Erfindung war.

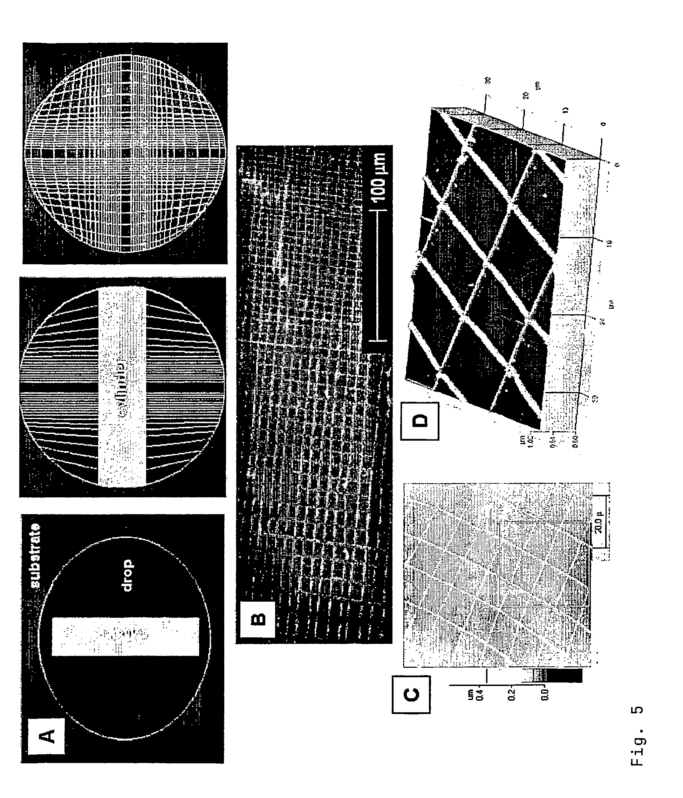

Um nun zu Gitterstrukturen zu gelangen, kann man erfindungsgemäß in denkbar einfacher Weise verfahren, wie Fig. 5 beweist. Nach dem Erzeugen einer ersten Nanodrahtanordnung wie zuvor beschrieben wird der Guide schlicht um einen Winkel, z.B. 90 °, verdreht und die Prozedur wird wiederholt. Dazu ist es nicht erforderlich, die im ersten Durchlauf erzeugten Strukturen zu fixieren, d.h. es können Salz-Nanodrähte bleiben. Sie werden durch den zweiten Benetzungsprozess keineswegs wieder aufgelöst. Fig. 5A zeigt Schema und erwartetes Ergebnis dieses Vorgehens.

Fig. 5B zeigt eine Rasterelektronenmikroskop-Aufnahme der dann entstehenden, nahezu regelmäßigen Gitterstruktur. Bei dieser großskaligen Aufnahme (ca. 0,4 mm breit) ist das Phänomen der sich verändernden Kapillarwellenlängen und damit der Strukturabstände deutlich zu erkennen. Die Kraftmikroskop-Bilder in Fig. 5C verdeutlichen eindrucksvoll die Regelmäßigkeit und Perfektion der Nanogitter, bei denen praktisch kein Material neben den Gitterlinien deponiert worden ist. Das Kreuzungsverhalten der Nanodrahtanordnungen erscheint völlig ungestört, d.h. das Vorhandensein der ersten Drähte hat die Erzeugung der zweiten offenbar in keiner Weise gestört.

Damit ist die Hoffnung begründet, dass sich auch sehr viel komplexere Strukturen, die eine Vielzahl separater Benetzungsvorgänge verlangen, mit hoher Qualität des Ergebnisses herstellen lassen.

Es sollte überdies noch betont werden, dass die Wahl eines geradlinigen Guide zum Auflegen auf das Substrat eine völlig willkürliche war. Selbstverständlich kann der Guide auch beliebig verkrümmt oder sogar eckig gestaltet sein, und er wird Nanodrahtanordnungen hervorrufen, die seine Form in seiner näheren Umgebung nachvollziehen (wenngleich die Ecken natürlich gerundet erscheinen werden). Insbesondere ist es für Zwecke der Herstellung z.B. auf industriellen Wafern gewiss zu bevorzugen, nicht nur einen einzelnen Guide, sondern eine angemessene Anordnung von mehreren Guides (etwa ein Gitterfenster oder dergleichen) zu benutzen.

Wie bereits erwähnt, ist man industriell eher an metallischen Drähten interessiert. Das vorbeschriebene Verfahren wird deshalb durch Erhitzen des mit Nanostrukturen versehenen Substrats auf Temperaturen um 200 °C abgeschlossen. Alle hier gezeigten Aufnahmen stellen bereits die hergestellten Silberstrukturen dar. Man wird sich bei der Nutzung der Erfindung sicherlich vorzugsweise auf Salze konzentrieren, die eine vergleichbar einfache Überführung in ein Metall gestatten.

## Patentansprüche

1. Verfahren zur Herstellung von regelmäßig angeordneten Nanodrähten aus einem Nanodrähte bildenden Material auf einem Substrat **gekennzeichnet durch** die folgenden Schritte:
a. Einbringen des Materials in eine Trägerflüssigkeit, wobei die Beladung der Trägerflüssigkeit mit dem Material wenigstens drei Größenordnungen unter der Beladungskapazität bleibt,
b. Auflegen eines Führungskörpers auf das Substrat,
c. Erwärmen des Substrats auf eine Temperatur, bei der ein dünner Film der Trägerflüssigkeit auf dem Substrat spinodale Entnetzung zeigt,
d. Aufbringen eines Filmes der mit Material beladenen Trägerflüssigkeit auf das erwärmte Substrat in der Umgebung des Führungskörpers, wo sich ein Gradient der mittleren Filmdicke senkrecht zur Kontur des Führungskörpers einstellt und
e. Verdampfenlassen der Trägerflüssigkeit unter Hinterlassen des Materials entlang senkrecht zum Gradienten der Filmdicke verlaufender Linien.

2. Verfahren nach Anspruch 1 zur Herstellung von sich überkreuzenden Nanodrahtanordnungen; **gekennzeichnet durch** wenigstens einmaliges Wiederholen der Schritte a - e unter jeweiligem Verdrehen des Führungskörpers um einen Winkel.

3. Verfahren nach Anspruch 1 oder 2, **dadurch gekennzeichnet, dass** das Nanodrähte bildende Material aus Kolloidpartikeln besteht, die in der Trägerflüssigkeit suspendiert werden.

4. Verfahren nach Anspruch 3, **dadurch gekennzeichnet, dass** als Kolloidpartikel Nanopartikel aus einem Edelmetall verwendet werden.

5. Verfahren nach Anspruch 1 oder 2, **dadurch gekennzeichnet, dass** das Nanodrähte bildende Material ein Salz ist, das in der Trägerflüssigkeit gelöst wird.

6. Verfahren nach Anspruch 5, **dadurch gekennzeichnet, dass** Edelmetallsalze verwendet werden.

7. Verfahren nach Anspruch 6, **dadurch gekennzeichnet, dass** Silbernitrat verwendet wird.

8. Verfahren nach Anspruch 7, **dadurch gekennzeichnet, dass** die erzeugten Nanodrähte aus Silbernitrat durch thermische Nachbehandlung um 200 °C in elementares Silber überführt werden.

9. Verfahren nach einem der vorangehenden Ansprüche, **dadurch gekennzeichnet, dass** als Substrate Siliziumwafer verwendet werden.

10. Verfahren nach einem der vorangehenden Ansprüche, **dadurch gekennzeichnet, dass** der Führungskörper eine Anordnung von Stäben mit mindestens einer Flachseite, die auf das Substrat gelegt wird, ist.

11. Verfahren nach einem der Ansprüche 1 - 9, **dadurch gekennzeichnet, dass** als Führungskörper ein einzelner Glaszylinder verwendet wird.

12. Verfahren nach einem der vorangehenden Ansprüche, **dadurch gekennzeichnet**, das Wasser als Trägerflüssigkeit verwendet und das Substrat auf Temperaturen zwischen 50°C und 80 °C erwärmt wird.

13. Verfahren nach den Ansprüchen 7 und 12, **dadurch gekennzeichnet, dass** eine 10⁻⁵ molare Silbernitratlösung hergestellt und auf das Substrat gebracht wird.

## Claims

1. A method for producing regularly arranged nanowires from a nanowire-forming material on a substrate, **characterized by** the following steps:
a. the material is introduced into a carrier liquid at a load remaining at least three orders of magnitude below the loading capacity of the carrier liquid,
b. a guiding member is placed on the substrate,
c. the substrate is heated to a temperature at which a thin film of the carrier liquid undergoes spinodal dewetting,
d. a film of the carrier liquid that is loaded with material is applied to the heated substrate in the surroundings of the guiding member, where a gradient of the average film thickness is obtained perpendicular to the contour of the guiding member, and
e. the carrier liquid is evaporated such that the material is left along lines extending perpendicular to the gradient of the film thickness.

2. The method according to Claim 1 for producing intersecting nanowire arrangements; **characterized by** repeating the steps a - e at least once while in each case rotating the guiding member through an angle.

3. The method according to Claim 1, **characterized in that** the nanowire-forming material consists of colloidal particles that are suspended in the carrier liquid.

4. The method according to Claim 3, **characterized in that** nanoparticles from a noble metal are used as colloidal particles.

5. The method according to Claim 1, **characterized in that** the nanowire-forming material is a salt that is dissolved in the carrier liquid.

6. The method according to Claim 5, **characterized in that** noble-metal salts are used.

7. The method according to Claim 6, **characterized in that** silver nitrate is used.

8. The method according to Claim 7, **characterized in that** the nanowires produced from silver nitrate are transferred into elemental silver by thermal post-treatment at about 200 °C.

9. The method according to Claim 1, **characterized in that** silicon wafers are used as the substrates.

10. The method according Claim 1, **characterized in that** the guiding member is an arrangement of rods having at least one flat side that is placed on the substrate.

11. The method according to Claim 1, **characterized in that** a single glass cylinder is used as a guiding member.

12. The method according to Claim 1, **characterized in that** water is used as carrier liquid and the substrate is heated to temperatures of between 50 °C and 80 °C.

13. The method according to Claim 7 and 12, **characterized in that** a 10⁻⁵ mol silver nitrate solution is prepared and brought onto the substrate.

## Revendications

1. Procédé de réalisation, sur un substrat, de nanofils disposés de façon régulière, à partir d'une matière formant nanofils, **caractérisé par** les étapes suivantes consistant à:
a. introduire la matière dans un liquide porteur, le chargement du liquide porteur en ladite matière restant au moins trois ordres de grandeur au-dessous de la capacité de chargement,
b. placer un corps de guidage sur ledit substrat,
c. chauffer ledit substrat à une température à laquelle un mince film du liquide porteur subit un démouillage spinodal sur le substrat,
d. appliquer un film du liquide porteur chargé en matière, sur le substrat chauffé aux environs dudit corps de guidage où s'établit un gradient de l'épaisseur moyenne de film perpendiculairement au contour du corps de guidage, et
e. faire évaporer le liquide porteur en laissant la matière le long de lignes s'étendant perpendiculairement au gradient de l'épaisseur de film.

2. Procédé selon la revendication 1, de réalisation d'agencements de nanofils se croisant, **caractérisé par le fait que** les étapes a à e sont répétées au moins une fois en tournant chaque fois d'un angle ledit corps de guidage.

3. Procédé selon la revendication 1 ou 2, **caractérisé par le fait que** la matière formant nanofils est constituée par des particules colloïdales qui sont mises en suspension dans le liquide porteur.

4. Procédé selon la revendication 3, **caractérisé par le fait que** l'on utilise des nanoparticules en un métal précieux en tant que particules colloïdales.

5. Procédé selon la revendication 1 ou 2, **caractérisé par le fait que** la matière formant nanofils est un sel qui est dissout dans le liquide porteur.

6. Procédé selon la revendication 5, **caractérisé par le fait que** l'on utilise des sels de métal précieux.

7. Procédé selon la revendication 6, **caractérisé par le fait que** l'on utilise du nitrate d'argent.

8. Procédé selon la revendication 7, **caractérisé par le fait que** les nanofils en nitrate d'argent produits sont transformés en argent élémentaire par un traitement thermique ultérieur à environ 200°C.

9. Procédé selon l'une quelconque des revendications précédentes, **caractérisé par le fait que** l'on utilise des tranches de silicium en tant que substrats.

10. Procédé selon l'une quelconque des revendications précédentes, **caractérisé par le fait que** ledit corps de guidage est un ensemble de barres ayant au moins une face plate qui est posée sur le substrat.

11. Procédé selon l'une quelconque des revendications 1 à 9, **caractérisé par le fait que** l'on utilise un cylindre unique en verre en tant que corps de guidage.

12. Procédé selon l'une quelconque des revendications précédentes, **caractérisé par le fait que** l'on utilise de l'eau en tant que liquide porteur et que le substrat est chauffé à des températures comprises entre 50°C et 80 °C.

13. Procédé selon les revendications 7 et 12, **caractérisé par le fait qu'**une solution de nitrate d'argent à 10⁻⁵ moles est préparée et est amenée sur le substrat.
